# NEUE EUROPÄISCHE PATENTSCHRIFT

(11) **EP 1 952 427 B2**
(45) Veröffentlichungstag und Bekanntmachung des Hinweises auf die Entscheidung über den Einspruch: **13.05.2015**
(45) Hinweis auf die Patenterteilung: 02.11.2011
(21) Anmeldenummer: 06829090.7
(22) Anmeldetag: 22.11.2006
(51) Int. Cl.: H01L 21/67, H01L 21/02

(54) **VORRICHTUNG UND VERFAHREN FÜR NASSCHEMISCHES PROZESSIEREN FLACHER, DÜNNER SUBSTRATE IM DURCHLAUFVERFAHREN**
APPARATUS AND METHOD FOR WET-CHEMICAL PROCESSING OF FLAT, THIN SUBSTRATES IN A CONTINUOUS METHOD
DISPOSITIF ET PROCÉDÉ POUR LE TRAITEMENT CHIMIQUE PAR VOIE HUMIDE DE SUBSTRATS PLATS ET MINCES EN CONTINU

(30) Priorität: 26.11.2005 DE 102005057109
(43) Veröffentlichungstag der Anmeldung: 06.08.2008
(73) Patentinhaber: acp-advanced clean production GmbH, 71254 Ditzingen (DE)
(72) Erfinder: KUNZE-CONCEWITZ, Horst, 75446 Wiernsheim (DE)
(74) Vertreter: DREISS Patentanwälte PartG mbB
(86) Internationale Anmeldenummer: PCT/EP2006/011166
(87) Internationale Veröffentlichungsnummer: WO 2007/059925

(56) Entgegenhaltungen:
- EP-A2- 0 718 871
- JP-A- 63 234 536
- US-B1- 6 261 377
- US-B1- 6 540 841

## Beschreibung

Die Erfindung betrifft ein Verfahren gemäß dem Anspruch 1 und eine Verwendung einer Vorrichtung gemäß dem Anspruch 3 zum nasschemischen Prozessieren flacher, dünner und bruchempfindlicher Substrate für mikroelektronische, mikromechanische und optische Anwendungen, bei denen die nasschemischen Prozesse, nämlich Beschichten im Durchlaufverfahren (Inline) bei Herstellung mikroelektronischer Bauelemente, Solarzellen etc. eingesetzt werden.

Die Nassprozesstechnik bei der Herstellung mikroelektronischer Bauelemente erfolgt gegenwärtig vorwiegend in Bad-Prozessen, bei denen die Substrate, untergebracht in Magazinen, in Prozessbäder getaucht werden. Die Prozessführung erfolgt diskontinuierlich in Horden von 1 - 50 Substraten. Zunehmend erfolgt der Einsatz von Durchlauf (Inline) - Nassprozess - Anlagen z.B. in der Solarzellenfertigung, bei denen die Substrate auf Rollen oder Bändern liegend kontinuierlich in Prozessbäder eingefahren werden bzw. in Sprühmodulen mit Medien wie z.B. Prozesschemikalien oder Wasser besprüht werden und danach mit Warmluft oder Stickstoff ggf. mit Isopropanol angereichert getrocknet werden. Die zur Zeit verfügbare, nasschemische Prozessführung beschränkt sich auf Tauchprozesse und Sprühprozesse die im wesentlichen für Standardsubstrate der Halbleiterindustrie entwickelt und optimiert wurden.

Aus der EP 0 718 871 A2 ist eine Reinigungsvorrichtung mit Bürsten bekannt, bei welcher das Substrat mittels Transportrollen transportiert wird. Dabei ist eine Kontamination vom einen zum Anderen Substrat nicht auszuschließen. Aus der US 6,261,377 B1 ist eine Reinigungsvorrichtung bekannt, welche für sehr dünne Substrate ungeeignet ist, da die Substrate nach dem Reinigungsvorgang abkippen. Die JP 63-234 536 A zeigt eine Reinigungsvorrichtung, bei welcher das Substrat von den Reinigungswalzen transportiert wird. Durch unterschiedliche Durchmesser, Geschwindigkeiten der Walzen usw. kann das Substrat von den Walzen beschädigt werden.

Die, den nächstkommenden Stand der Technik darstellende US 6,540,841 B1 zeigt eine Reinigungsvorrichtung, bei der das Substrat in Rotation versetzt und mit eine Walze gereinigt wird. Der Transport ist diskontinuierlich und das Verfahren ist für einen Inline-Prozess ungeeignet.

US 6,247,197 B1 offenbart ein Bürstenreinigungsgerät für Halbleiterwafer.

In der modernen Mikroelektronik und Dünnfilmtechnik kommen zukünftig immer dünnere Substrate zum Einsatz z.B. von Substratdicken kleiner 100 µm. Diese beinahe folienartigen, sehr bruchempfindliche Substrate können in Magazinen und Tauchbecken nicht prozessiert werden, da einerseits die Anforderungen an Transportstabilität, andererseits auch die Produktivitätskriterien nicht erfüllt werden. Auch Prozessanforderungen wie einseitiges Prozessieren ist nicht möglich. Vorhandene Inline Prozessanlagen für das gleichzeitige Prozessieren einer großen Anzahl solcher Substrate im Durchlaufverfahren erfüllen zwar die Durchsatzkriterien, weisen jedoch unakzeptable Bruchraten auf und können nicht für alle benötigten Arten der Prozessführung eingesetzt werden.

Diese Probleme werden durch die Merkmale des Anspruchs 1 und/oder des Anspruchs 3 gelöst.

Das nachfolgend beschriebene Verfahren und die beschriebene Vorrichtung zur Durchführung des Verfahrens erfüllen alle Anforderungen für eine Inline - Prozesseinrichtung für dünne bruchempfindliche Substrate sowohl bezüglich des Transportes (Handlings) innerhalb der Prozessstrecke, als auch bezüglich der erweiterten Prozessführung für alle benötigten Applikationen durch Einsatz mikroporöser, kompressibler Walzen. Durch die Verwendung solcher Walzen werden Kräfte senkrecht zur Transportrichtung vermieden, gleichzeitig erlauben die Rollen eine gleichförmige Benetzung der Substrate mit Prozessmedien, entweder beidseitig oder nur auf die Vorder- oder Rückseite des Substrates. Dadurch sind in der Prozessführung durch kontrollierte Wechselwirkung mit Prozessmedien sowohl chemische als auch durch direkten Reinigungskontakt physikalische Verfahren wirksam. Darüber hinaus kann im gleichen Verfahren ein Spül- und Trockenschritt integriert werden.

In dem vorliegenden Verfahren werden die zu prozessierenden Substrate im Durchlaufverfahren über einseitig oder beidseitig installierte, rotierende, medienkompatible Schwammrollen geführt. Eine absolut gleichförmige Bewegung wird durch, zumindest einseitige Kopplung der Antriebe erreicht. Die für die gewünschte Prozeßführung benötigten Medien (flüssig oder gasförmig) werden beim Durchlauf direkt oder indirekt aufgebracht, bzw. in Spül- und Trockenschritten wieder entfernt. Je nach Ausführungsform kann die Prozeßführung auf den Substraten einseitig oder beidseitig erfolgen, mehrere Prozeßschritte (mit gleichem oder unterschiedlichen Medien) können durch Aneinanderreihung von Prozeßmodulen in einer Prozeßlinie kombiniert werden. Diese kann ein oder mehrspurig sein. Das Verfahren kann sowohl mit benetzten oder trockenen Substraten abschließen.

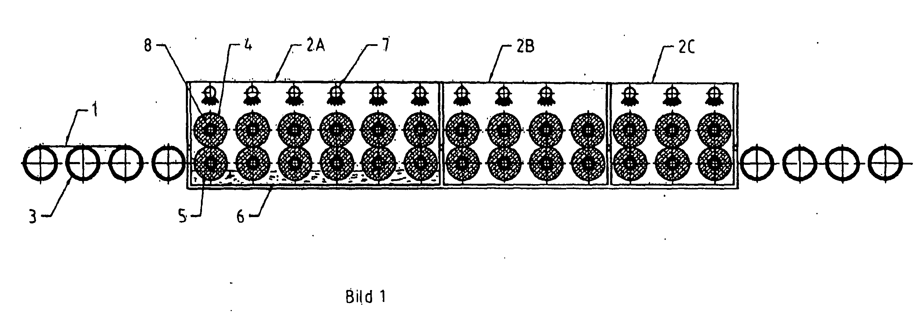

Beschreibung verschiedener Ausführungsformen und Illustrationen:
Die zu bearbeitenden Substrate 1 (Bild 1) werden horizontal einem Prozessmodul 2A zugeführt. Die Zuführung erfolgt dadurch, dass das Substrat auf Rollen 3 bzw. auf Bändern oder Riemen, oder durch ein alternatives Handlingsystem (z.B. Roboter) zu den Walzen 4 und 5 des Prozessmoduls 2A transportiert wird.

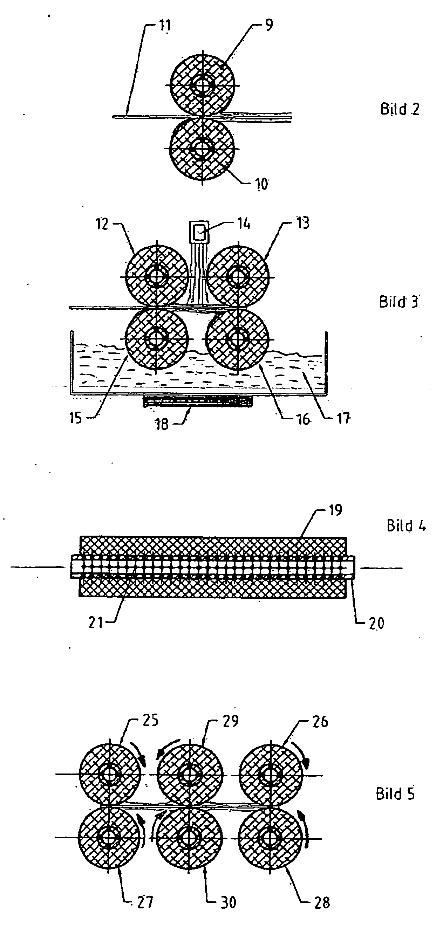

Sobald das Substrat von den porösen, komprimierbaren Walzen 4 und 5 erfasst wird, erfolgt der Weitertransport des Substrates durch gleichartige, nachfolgende Walzen des Prozessmoduls 2A. Die Walzen zeichnen sich dadurch aus, dass sie das im Prozessmodul 2A verwendete Prozessmedium, welches aus einem Tauchbad 6 oder Sprühvorrichtung 7 oder direkt durch den Kern der Walzen 8 zugeführt wird, absorbieren und beim Substrattransport durch den Kontakt der Walzen 9 und 10 (Bild 2) mit der Oberfläche des Substrates 11 das Prozessmedium auf die Substratoberfläche übertragen. Durch das Abrollen der mit Prozessmedium gespeisten Walze auf der Substratoberfläche erfolgt zudem ein den Prozessverlauf unterstützender Reibungseffekt welcher die Prozessführung beim Reinigen, Ätzen, Strippen, Spülen intensiviert.

In einem alternativen Verfahren, welches auch mit dem oben beschriebenen kombiniert ist kann der Abstand der Walzen 12 und 13 (Bild 3) so gestaltet werden, dass zwischen den Walzen 12 und 13 eine zusätzliche Zuführung von Prozessmedien durch Sprühdüsen 14 erfolgen kann. Die Sprühdüsen können zudem als Ultraschall oder Megaschalldüsen ausgeführt werden.

Die Benetzung der unteren Walzen 15 und 16 kann wahlweise durch direkte Aufnahme des Prozessmediums aus Wanne 17 oder entsprechend der oben beschriebenen Ausführung der oberen Walzen über Sprühdüsen erfolgen und kann zudem durch eine Ultraschall- oder Megaschallanregung (18) des Prozessmediums unterstützt werden. Die Medienzuführung zur Walze 19 (Bild 4) kann auch durch den Walzenkern 20 erfolgen in dem der Walzenkern mit Bohrungen 21 für Medienauslass versehen ist. Durch die mikroporöse Struktur der Walze gelangt das Prozessmedium in den Walzenkörper bzw. Walzenoberfläche und in der beschriebenen Vorrichtung auf die Oberflächen des zu prozessierenden Substrates.

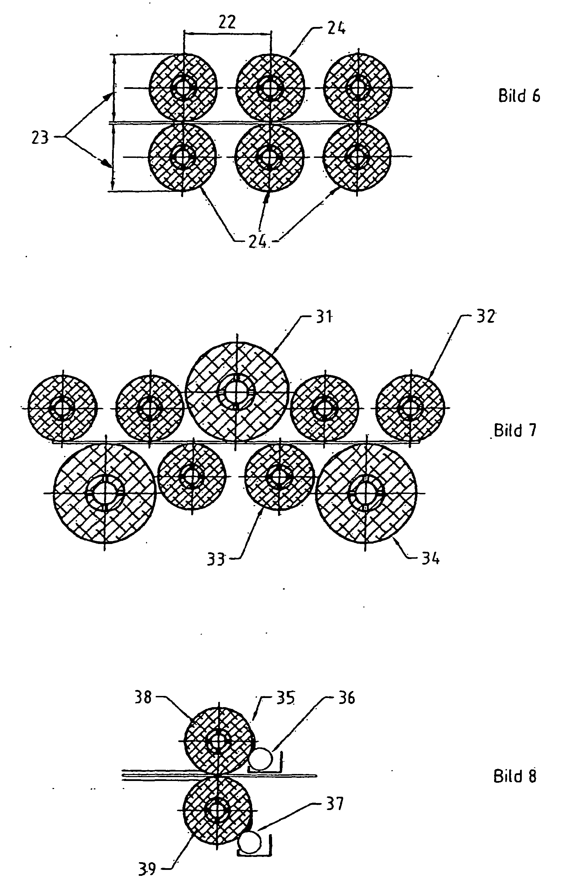

Abhängig von der Substratart und gewünschten Prozessführung kann sowohl der vertikale Abstand 23 der Walzen gegenüber dem Substrat (Bild 6), als auch der horizontale Abstand 22 der Walzen zueinander sowie Walzenanzahl 24 gemäß den Prozessanforderungen und Substratart ausgeführt werden. Ebenso kann der Andruck der Walzen auf das Substrat entsprechend der gewünschten Prozessführung und Substratart über Festeinstellung, Schwerkraft (Druck der oberen Walzen auf die unteren) oder durch Stellantriebe (pneumatisch, elektrisch oder hydraulisch) erfolgen.

Die Walzenrotation erfolgt über elektrische Antriebe bei dem die Walzenumdrehung und somit der Substrattransport kontinuierlich regelbar ist.

Alternativ ist eine nicht patentgemäße Prozessführung mit gegenläufigem Walzendrehsinn z.B. bei Reinigungsprozessen dadurch möglich (Bild 5), dass der Walzenandruck der den Substrattransport ausführenden Walzen 25, 26, 27 und 28 entsprechend größer gegenüber dem Substrat ist als der Walzenandruck der Walzen 29 und 30 und die Walzen 29 und 30 entgegen dem Drehsinn der Walzen 25, 26, 27 und 28 rotieren bzw. entgegen der Transportrichtung des Substrates wodurch ein zusätzlicher Reinigungseffekt entsteht. Ebenso ist der Transport und die Prozessführung durch Einsatz von Walzen mit unterschiedlichen Walzendurchmessern (Bild 7) 31, 32, 33 und 34 in Kombination dieser angepasst an die Prozessführung möglich (siehe Bild 7). Zudem kann die Drehzahl einzelner Walzen einzeln geregelt sein und in Kombination mit Walzendruck und Walzendrehsinn jeder Walze zugeordnet werden, um entsprechende Prozessführung bei den einzelnen Prozessen zu erreichen.

Andere Prozessmodule bei unterschiedlicher, nacheinander folgender Prozessführung z.B. Ätzen, Spülen, Trocknen können hintereinander in einer Linie aufgebaut sein 2A, 2B, 2C (siehe Bild 1) und durch Trennwände versehen mit einem Schlitz für den durchgehenden Substrattransport bezüglich der unterschiedlichen Prozessmedien zueinander abgegrenzt sein. Die Abgrenzung der Prozessmodule zueinander kann auch alleine durch die Walzen und entsprechende Prozessmedienzufuhr erfolgen in dem zu den letzten Walzen innerhalb eines Prozessmoduls reduzierte Medienzuführung erfolgt.

Die Trocknung der Substratoberfläche z.B. nach Sprühprozessen erfolgt ebenfalls weitestgehend durch die mikroporösen Walzen. Diesen Walzen wird jedoch kein Prozessmedium zugeführt. Durch Abrollen der trockenen Walze über die Substratoberfläche erfolgt eine Flüssigkeitsaufnahme von der Oberfläche durch die Walze (siehe Bild 8). Die aufgenommene Flüssigkeit wird durch zusätzliches Abstreifen bzw. Abrollen 36 und 37 (Bild 8) der zur Trocknung eingesetzten Walze 38 und 39 kontinuierlich entnommen und dadurch die Walze für weitere Feuchtigkeitsaufnahme in einem Prozessdurchlauf präpariert. Ebenso kann die Abführung der von der Walze absorbierten Flüssigkeit von der Substratoberfläche dadurch erfolgen, dass die aufgenommene Flüssigkeit durch den gelochten Walzenkern 20 (Bild 4) über Unterdruck aus der Walze abgesaugt wird.

In einer zweiten nicht patentgemäßen Ausführungsform kann die Oberflächentrocknung nach der Aufnahme der Flüssigkeit durch Abrollen der Walzen auf der Substratoberfläche dadurch erfolgen, dass die Substratoberfläche nach der letzten Walze mit Gasen aufgeblasen wird, die zudem erwärmt sein können wie geheiztem Stickstoff oder Warmluft sowie durch Substraterwärmung z.B. durch Infrarotstrahlung oder Heizstäbe bzw. in Kombination der beschriebenen Verfahren.

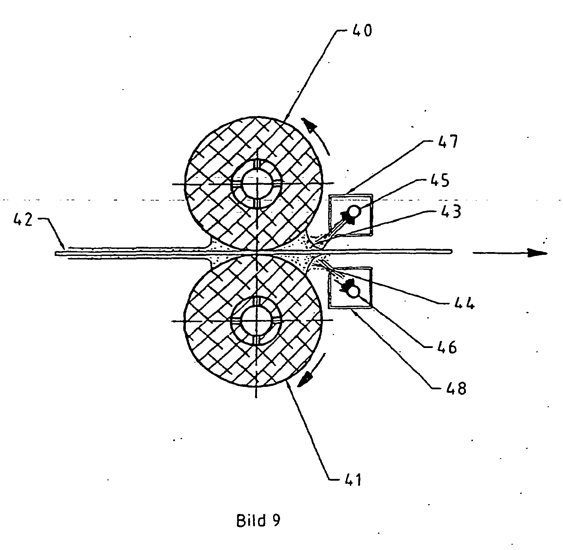

In einer weiteren, nicht patentgemäßen Ausführungsform kann eine rückstandsfreie Oberflächentrocknung der Substrate durch Einleiten eines Gas-Dampf-Gemisches in die Flüssigkeit auf der Substratoberfläche erfolgen, bei welchem der Dampf mit der Flüssigkeit mischbar ist und durch die Mischung eine Reduzierung der Oberflächenspannung der Flüssigkeit an der Grenzfläche zwischen Substrat- und Walzenoberfläche gegenüber der Flüssigkeit ohne Dampfbeimischung zur Folge hat. Dieses als Marangoni- oder Oberflächenspannungsgradienttrocknung bekannte Verfahren kann wie in Bild 9 dargestellt auf die vorliegende Erfindung übertragen werden. Durch das Abrollen der Walzen 40 bzw. 41 führt die zuvor von der nassen Substratoberfläche beim Abrollen durch die Walzen aufgenommene Flüssigkeit oder den Walzen zusätzlich zugeführte Flüssigkeit gemäß den zuvor beschriebenen Möglichkeiten zu einer Meniskusbildung zwischen Walze und Substratoberfläche. Aus Düsen 45 bzw. 46 wird das Gas-Dampf-Gemisch in Richtung des Flüssigkeitsminiskus durch strömungsführende Austritte 47 bzw. 48 geleitet. Durch Eindringen von Dampf in dem Flüssigkeitsminiskus erfolgt eine Vermischung und somit auch eine Reduzierung der Oberflächenspannung gegenüber der Flüssigkeit außerhalb des Meniskus. Es resultiert eine Kraft (Manrangonikraft) in Richtung des Flüssigkeitsbereiches mit höherer Oberflächenspannung außerhalb des Meniskus, wodurch das Substrat getrocknet wird. Diese Trocknung ist weitestgehend frei von Partikeln und Rückständen.

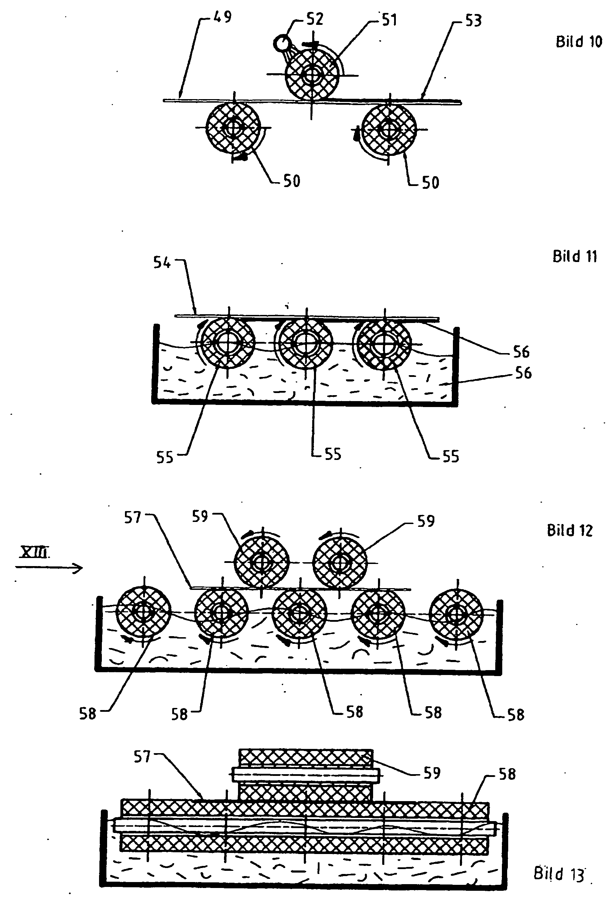

Die einseitige Oberflächenbehandlung eines flachen Substrates kann dadurch erfolgen, dass das Substrat 49 (Bild 10) auf Transportwalzen 50 einer Prozesswalze 51 zugeführt wird, die mit Prozessmedium 52 versorgt wird und beim Abrollen über das Substrat das Prozessmedium 53 auf die Substratoberfläche überträgt. Durch die entsprechende Anordnung der Transportwalzen 50 wird verhindert, dass diese mit der Prozesswalze 51 in Kontakt kommen.

Eine weitere Möglichkeit der einseitigen Oberflächenbehandlung kann dadurch erfolgen indem das Substrat 54 (Bild 11) mit der zur prozessierenden Oberfläche durch Walzen 55 transportiert wird, die in ein Prozessmedium eintauchen und bei der Rotation der Walzen beim Substrattransport dieses Mediums 56 auf die Substratunterseite übertragen. Wird dieses Substrat 57 (Bild 12) zudem gegen die weichen Walzen 58 durch Andruckwalzen 59 (Bild 13) gedrückt, erfolgt auch eine Behandlung der Substratkante mit dem Prozessmedium.

## Patentansprüche

1. Verfahren zum nasschemischen Prozessieren, nämlich zum Beschichten von Oberflächen von flachen, dünnen, bruchempfindlichen Substraten, z.B. von mikroelektronischen Bauelementen, Solarzellen, etc., im Durchlaufverfahren, wobei der Substrattransport als auch die Prozessführung durch Prozessmedien absorbierende, mikroporöse Walzen erfolgt, indem das in der Walze absorbierte Prozessmedium beim Substrattransport durch das Abrollen der Walze auf die Substratoberfläche übertragen wird, **dadurch gekennzeichnet, dass** die Walzen durch zumindest einseitige Kopplung der Antriebe absolut gleichförmig bewegt werden und eine gleichförmige Benetzung der Substrate mit dem Prozessmedium erfolgt.

2. Verfahren nach Anspruch 1, **dadurch gekennzeichnet, dass** die nasschemische Behandlung auf nur einer Seite des Substrates oder beidseitig erfolgt.

3. Verwendung einer Vorrichtung zum nasschemischen Prozessieren, nämlich zum Beschichten von Oberflächen von flachen, dünnen, bruchempfindlichen Substraten, z.B. von mikroelektronischen Bauelementen, Solarzellen, etc., im Durchlaufverfahren, wobei absorbierende, mikroporöse Walzen der Vorrichtung zum Substrattransport als auch zur Prozessführung durch Prozessmedien vorgesehen sind, welche auf der Substratoberfläche abrollen und dabei das in der Walze absorbierte Prozessmedium übertragen, **dadurch gekennzeichnet, dass** sich die Walzen absolut gleichförmig bewegen, indem ihre Antriebe zumindest einseitig gekoppelt sind und dass eine gleichförmige Benetzung der Substrate mit dem Prozessmedium erfolgt.

4. Verwendung einer Vorrichtung nach Anspruch 3, **dadurch gekennzeichnet, dass** ein Medienbad vorgesehen ist, und die Walze in das Medienbad eintaucht und das Prozessmedium aufnimmt.

5. Verwendung einer Vorrichtung nach Anspruch 3 oder 4, **dadurch gekennzeichnet, dass** eine Sprühvorrichtung vorgesehen ist, so dass die Zuführung des Prozessmediums zur Walze durch Aufsprühen auf die Walze und/oder durch Dosieren des Prozessmediums zwischen den Walzen erfolgt.

6. Verwendung einer Vorrichtung nach einem der Ansprüche 3 bis 5, **dadurch gekennzeichnet, dass** die Walzen übereinander angeordnet sind und die Lage der übereinander angeordneten Walzen beliebig ist.

7. Verwendung einer Vorrichtung nach einem der Ansprüche 3 bis 6, **dadurch gekennzeichnet, dass** der Abstand und/oder der Andruck der oberen zu den unteren Walzen einstellbar ist.

8. Verwendung einer Vorrichtung nach einem der Ansprüche 3 bis 7, **dadurch gekennzeichnet, dass** die Drehzahl einzelner Walzen einzeln einstellbar ist.

9. Verwendung einer Vorrichtung nach einem der Ansprüche 3 bis 8, **dadurch gekennzeichnet, dass** der Drehsinn (Drehrichtung) einzelner Walzen unterschiedlich wählbar ist.

10. Verwendung einer Vorrichtung nach einem der Ansprüche 3 bis 9, **dadurch gekennzeichnet, dass** die absorbierte Flüssigkeit der Walze durch Absaugen aus der Walze ableitbar ist.

11. Verwendung einer Vorrichtung nach einem der Ansprüche 3 bis 10, **dadurch gekennzeichnet, dass** mehrere Prozesskammern hintereinander zu einer Prozesslinie angeordnet sind, um Ätzprozesse, Spülprozesse, Trocknungsprozesse etc. nacheinander durchführen zu können.

12. Verwendung einer Vorrichtung nach einem der Ansprüche 3 bis 11, **dadurch gekennzeichnet, dass** das oder die Prozessmedien nur einer Substratseite und dem Substratrand zuführbar ist.

## Claims

1. A method for wet-chemical processing, namely for coating of surfaces of flat, thin, breakage-sensitive substrates, e.g. of microelectronic components, solar cells etc., in the passage process, wherein the substrate transport as well as the process control are effected by microporous rollers absorbing process media by transferring the process medium absorbed in the roller to the substrate surface by roll-over of the roller upon substrate transport, **characterized in that** the rollers are absolutely uniformly moved by at least one-side coupling of the drives, and uniform wetting of the substrates with the process medium is effected.

2. The method according to claim 1, **characterized in that** the wet-chemical treatment is effected only on one side of the substrate or on both sides.

3. Use of an apparatus for wet-chemical processing, namely for coating of surfaces of flat, thin, breakage-sensitive substrates, e.g. of microelectronic components, solar cells etc., in the passage process, wherein absorbing, microporous rollers of the apparatus are provided for substrate transport as well as for the process control by process media, which roll over the substrate surface and therein transfer the process medium absorbed in the roller, **characterized in that** the rollers move absolutely uniformly by their drives being coupled at least on one side, and that uniform wetting of the substrates with the process medium is effected.

4. Use of an apparatus according to claim 3, **characterized in that** a medium bath is provided and the roller immerses in the medium bath and absorbs the process medium.

5. Use of an apparatus according to claim 3 or 4, **characterized in that** a spray device is provided such that the supply of the process medium to the roller is effected by spraying onto the roller and/or by metering the process medium between the rollers.

6. Use of an apparatus according to any one of claims 3 to 5, **characterized in that** the rollers are disposed one above the other and the position of the rollers disposed one above the other is arbitrary.

7. Use of an apparatus according to any one of claims 3 to 6, **characterized in that** the distance and/or the contact pressure of the upper to the lower rollers is adjustable.

8. Use of an apparatus according to any one of claims 3 to 7, **characterized in that** the rotational speed of individual rollers is individually adjustable.

9. Use of an apparatus according to any one of claims 3 to 8, **characterized in that** the sense of rotation (direction of rotation) of individual rollers can be selected in different ways.

10. Use of an apparatus according to any one of claims 3 to 9, **characterized in that** the absorbed liquid of the roller can be drained by sucking off from the roller.

11. Use of an apparatus according to any one of claims 3 to 10, **characterized in that** a plurality of process chambers are successively disposed to a process line in order to be able to sequentially perform etching processes, rinsing processes, drying processes etc.

12. Use of an apparatus according to any one of claims 3 to 11, **characterized in that** the process medium or media can only be supplied to one substrate side and the substrate edge.

## Revendications

1. Procédé pour le traitement chimique par voie humide, à savoir pour le revêtement, en continu, de surfaces de substrats plats minces et sensibles à la rupture, par exemple de composants microélectroniques, de cellules photovoltaïques etc., dans lequel le transport des substrats de même que la conduite du processus sont réalisés par l'intermédiaire de cylindres microporeux absorbant des milieux de processus, en transférant le milieu de processus absorbé dans le cylindre à la surface du substrat, durant le transport du substrat, par le roulement du cylindre, **caractérisé par le fait que** lesdits cylindres sont déplacés d'une manière absolument uniforme par un accouplement au moins unilatéral des mécanismes d'entraînement et que les substrats sont mouillés uniformément du milieu de processus.

2. Procédé selon la revendication 1, **caractérisé par le fait que** le traitement chimique par voie humide n'est réalisé que sur une face du substrat ou est réalisé sur les deux faces.

3. Utilisation d'un dispositif pour le traitement chimique par voie humide, à savoir pour le revêtement, en continu, de surfaces de substrats plats minces et sensibles à la rupture, par exemple de composants microélectroniques, de cellules photovoltaïques etc., dans lequel des cylindres microporeux absorbants du dispositif sont prévus pour le transport des substrats de même que pour la conduite du processus par le biais de milieux de processus, qui défilent en roulant sur la surface du substrat tout en transférant le milieu de processus absorbé dans le cylindre, **caractérisé par le fait que** lesdits cylindres, dû au fait que leurs mécanismes d'entraînement sont accouplés au moins unilatéralement, se déplacent d'une manière absolument uniforme et que les substrats sont mouillés uniformément du milieu de processus.

4. Utilisation d'un dispositif selon la revendication 3, **caractérisé par le fait que** l'on prévoit un bain de milieu et que le cylindre plonge dans ledit bain de milieu absorbant ainsi le milieu de processus.

5. Utilisation d'un dispositif selon la revendication 3 ou 4, **caractérisé par le fait que** l'on prévoit un dispositif de pulvérisation de sorte que l'amenée du milieu de processus au cylindre se fait par une pulvérisation sur ledit cylindre et/ou par un dosage du milieu de processus entre les cylindres.

6. Utilisation d'un dispositif selon l'une quelconque des revendications 3 à 5, **caractérisé par le fait que** les cylindres sont superposés et que la position des cylindres superposés peut être n'importe quelle.

7. Utilisation d'un dispositif selon l'une quelconque des revendications 3 à 6, **caractérisé par le fait que** la distance et/ou la pression des cylindres supérieurs aux cylindres inférieurs est réglable.

8. Utilisation d'un dispositif selon l'une quelconque des revendications 3 à 7, **caractérisé par le fait que** la vitesse de rotation de cylindres particuliers peut être réglée individuellement.

9. Utilisation d'un dispositif selon l'une quelconque des revendications 3 à 8, **caractérisé par le fait que** le sens de rotation (direction de rotation) de cylindres particuliers peut être choisi différemment.

10. Utilisation d'un dispositif selon l'une quelconque des revendications 3 à 9, **caractérisé par le fait que** le liquide absorbé du cylindre peut être évacué par aspiration dudit cylindre.

11. Utilisation d'un dispositif selon l'une quelconque des revendications 3 à 10, **caractérisé par le fait que** plusieurs chambres de processus sont disposées les unes derrière les autres de manière à former une ligne de processus, afin de pouvoir réaliser des processus d'attaque, des processus de rinçage, des processus de séchage etc. les uns à la suite des autres.

12. Utilisation d'un dispositif selon l'une quelconque des revendications 3 à 11, **caractérisé par le fait que** le ou les milieu(x) de processus peut (peuvent) être amené(s) à une face du substrat et au bord du substrat seulement.
